# EUROPEAN PATENT APPLICATION

(11) **EP 3 671 981 A1**
(43) Date of publication of application: **24.06.2020**
(21) Application number: 18215251.2
(22) Date of filing: 21.12.2018
(51) Int. Cl.: H01S 5/026, H01S 5/22, H01S 5/20, H01S 5/02

(54) **III-V-ON-SILICON NANORIDGE OPTO-ELECTRONIC DEVICE WITH CARRIER BLOCKING LAYERS**

(71) Applicant: IMEC vzw, 3001 Leuven (BE)
(72) Inventor: De Koninck, Yannick, 3001 Leuven (BE); Van Campenhout, Joris, 3001 Leuven (BE)
(74) Representative: Roth, Sebastian

(57) **Abstract**

The present invention relates to the development of a monolithic active electro-optical device. The electro-optical device may be fabricated using the so-called nanoridge aspect ratio trapping (ART) approach. In particular, the invention proposes a monolithic integrated electro-optical device, which comprises a III-V-semiconductor-material ridge structure provided on a Si-based support region. The ridge structure includes a first-conductivity-type bottom region provided on the support region, a first-conductivity-type lower blocking layer provided on the top surface and parts of the side surfaces of the bottom region and configured to block second-conductivity-type charge carriers, a not-intentionally-doped (NID) intermediate region provided on the top and side surfaces of the lower blocking layer and containing a recombination region, a second-conductivity-type upper blocking layer provided on the top and side surfaces of the intermediate region and configured to block first-conductivity-type charge carriers, and a second-conductivity-type top region provided on the top and side surfaces of the upper blocking layer.

## Description

### TECHNICAL FIELD

The present invention relates to the development of a monolithic active electro-optical device (e.g. a Light Emitting Diode (LED), a LASER, a modulator, or a photo-detector). The electro-optical device may be fabricated using the so-called nanoridge aspect ratio trapping (ART) approach. In particular, the invention proposes a monolithic integrated electro-optical device, which comprises a III-V-semiconductor-material ridge structure provided on a Si-based support region.

### BACKGROUND OF THE INVENTION

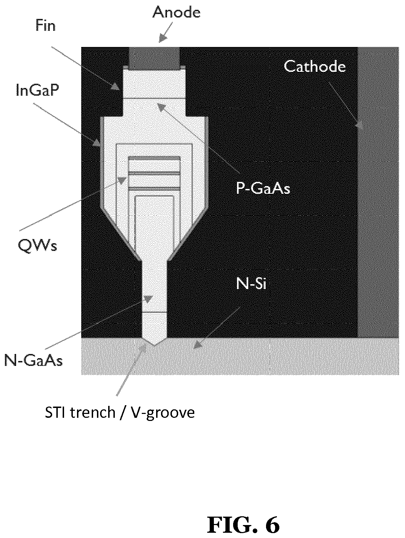

An example of a monolithic integrated electro-optical device fabricated with the nanoridge ART approach is shown in FIG. 6. The electro-optical device includes a III-V semiconductor material (e.g. GaAs) ridge structure, which is grown in a narrow Shallow Trench Isolation (STI) trench on a silicon V-groove formed in a Si support layer. The STI trench has a high aspect ratio (i.e. a ratio of its depth vs. its width is larger than at least 1), which has the advantage that misfits and dislocation defects are efficiently trapped (thus called ART) as soon as the III-V semiconductor material is grown inside the trench, and therefore the outgrown III-V semiconductor ridge material, i.e. the freestanding ridge structure, is free of defects.

In the electro-optical device of FIG. 6, the Si support layer is highly n-doped, and is in contact with a metallic interface (the cathode - e.g. realized by a W contact plug). The ridge structure itself comprises:
- An n-doped III-V semiconductor material (e.g. GaAs) region arranged near the bottom of the ridge structure and contacting the n-doped Si support layer in the trench.
- A not-intentionally doped (NID) III-V semiconductor material (e.g. GaAs) region arranged in the center of the ridge structure, and containing a narrower bandgap active/recombination region (e.g. including one or more quantum wells, or one or more layers of quantum dots).
- A p-doped III-V semiconductor material (e.g. GaAs) region arranged at the top of the ridge structure, which is in contact with a metallic interface (the anode - e.g. realized by a W contact plug).
- A capping layer of a higher band-gap III-V material (e.g. InGaP, lattice matched to e.g. the GaAs of the ridge structure) grown around the III-V semiconductor material ridge structure, particularly around a wider portion thereof. The capping layer has a conduction and/or valence band offset, which is sufficiently high to prevent at least one species of charge carriers (i.e. electrons and/or holes) to penetrate into the capping layer and to reach its surface interface with a dielectric, which encapsulate the ridge structure and the capping layer.
- A region near the top of the ridge structure, where III-V semiconductor material was removed by etching, in order to form a narrower top portion (referred to as 'fin' or 'fin structure'). The purpose of this fin structure is to push - in operation of the electro-optical device - the optical waveguide mode downwards, i.e. away from the metallic anode. This reduces the modal absorption loss, while still providing a channel for injecting electrical current into the III-V semiconductor material ridge structure, specifically into the active region.

A passive waveguide (e.g. a Si-waveguide) can be brought into close proximity of the active region of the ridge structure, for instance, for evanescent coupling of optical power into and out of the ridge structure.

However, in order to obtain a laser operation of the electro-optical device shown in FIG. 6, a significant amount of charge carriers must be available in the recombination region (e.g. the quantum wells or dots) to recombine radiatively and to support a stimulated emission. Unfortunately, non-radiative recombination processes - such as Shockley-Read-Hall and Auger recombination - provide alternative routes for charge carriers to recombine, and thus reduce the charge carrier density in the laser active region.

In particular, interfaces between untreated III-V semiconductor material (e.g. GaAs) and the surrounding dielectric suffer from high surface Shockley-Read-Hall recombination rates (e.g. the surface recombination velocity may be in the order of 1E+6 cm/s).

Any recombination mechanism is limited by the supply of minority charge carriers. This means for the electro-optical device shown in FIG. 6 that:
- Surface recombination is lower in highly-doped III-V semiconductor material/dielectric interfaces, because minority charge carriers (i.e. electrons in p-doped regions, and holes in n-doped regions) are prevented from penetrating into these regions, due to the strong electric fields present at the depletion region.
- Surface recombination is lower in the capping layer/dielectric interface, because the high valence-band offset between the III-V semiconductor material (e.g. GaAs) and the capping layer (e.g. InGaP) will prevent holes from penetrating into the capping layer and from reaching the capping layer/dielectric interface, where they could recombine with electrons.

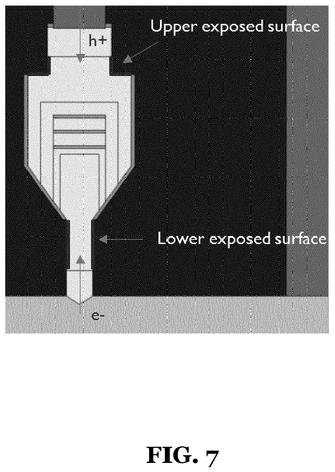

However, FIG. 7 shows that there are still regions in the III-V semiconductor material ridge structure of the electro-optical device, where lowly-doped III-V semiconductor material (e.g. GaAs), which contains significant densities of both electrons and holes, is exposed to the surrounding dielectric. This potentially leads to higher surface recombination rates, which can significantly decrease the laser performance of the electro-optical device, and can even inhibit electrically injected laser operation.

The regions where lowly-doped III-V semiconductor material regions are exposed to the dielectric are in particular:
- The III-V semiconductor material (e.g. GaAs) regions at the top of the ridge structure, which are created by etching the fin structure (labelled 'upper exposed surface' in FIG. 7).
- The III-V semiconductor material (e.g. GaAs) narrower portion arranged near the bottom of the ridge structure and contacting the n-doped Si layer (labelled 'lower exposed surface' in FIG. 7).

### SUMMARY OF THE INVENTION

In view of the above-mentioned disadvantages, embodiments of the present invention aim to provide an improved electro-optical device. An objective is in particular to provide an electro-optical device with a ridge structure, which shows better lasing abilities. To this end, a main goal is to reduce or even eliminate surface recombination at exposed III-V semiconductor material regions, in order to maximize charge carries densities in the active/recombination region of the electro-optical device.

The objective is achieved by the embodiments of the invention provided in the enclosed independent claims. Advantageous implementations of these embodiments are defined in the dependent claims.

The embodiments base on the following considerations. As noted earlier, the surface recombination rate is limited by the supply of the least available charge carrier species (i.e. the 'minority charge carrier' type). Consequently, surface recombination can be limited already by preventing one species of charge carriers (electrons or holes) to reach the critical surface. In the example cross-section of the device shown in FIG. 6, the n-doped layer is arranged on the bottom of the ridge structure, and the p-doped layer is arranged on the top of the ridge structure. This means that, as indicated in FIG. 7, electrons are injected into the ridge structure from the bottom and holes are injected from the ridge structure from the top.

As also discussed above, there are two critical surfaces shown in FIG. 7, namely the exposed surfaces on the top, due to the fin structure etch, and the exposed surfaces near the bottom of the ridge structure, particularly because the narrower portion of the ridge structure is not surrounded by capping layer. Surface recombination could be reduced significantly in this exemplary electro-optical device, if electrons were prevented from reaching the upper exposed surface and if holes were prevented from reaching the lower exposed surface.

Thus, the embodiments of the present invention base on the idea of providing two additional III-V semiconductor material blocking layers during the formation of the ridge structure: One blocking layer is formed prior to forming the recombination region (referred to as the "lower blocking layer") and one blocking layer is formed after forming the recombination region (referred to as the "upper blocking layer"). The lower blocking layer is configured to block second-conductivity-type charge carriers and to let first-conductivity-type charge carriers flow through. The upper blocking layer is configured to block first-conductivity-type charge carriers and to let second-conductivity type charge carriers flow through.

A first aspect of the invention provides a monolithic integrated electro-optical device, comprising: a first-conductivity-type Si-based support region; and a III-V-semiconductor-material ridge structure extending from the Si-based support region, the ridge structure including: a first-conductivity-type bottom region provided on the support region, a first-conductivity-type lower blocking layer provided on the top surface and parts of the side surfaces of the bottom region and configured to block second-conductivity-type charge carriers, a not-intentionally-doped, NID, intermediate region provided on the top and side surfaces of the lower blocking layer and containing a recombination region, a second-conductivity-type upper blocking layer provided on the top and side surfaces of the intermediate region and configured to block first-conductivity-type charge carriers, and a second-conductivity-type top region provided on the top and side surfaces of the upper blocking layer.

Accordingly, the two charge carrier blocking layers are both non-planar layers. In particular, the charge carrier blocking layers are (at least partly) wrapped around the respective regions beneath. Thereby, the blocking layers are particularly conformal with the upper surface of the respective regions beneath. That is, the upper blocking layer may be wrapped around the intermediate region, and the lower blocking layer may be wrapped around the bottom region.

The lower blocking layer is in particular configured to block the second-conductivity-type charge carriers and to let first-conductivity-type charge carriers pass. The upper blocking layer is in particular configured to block the first-conductivity-type charge carriers and to let second-conductivity type charge carriers pass. To this end, the respective doping impurities (of different conductivity-types) are added to the two blocking layers, and also to some regions of the ridge structure. In particular, the lower blocking layer and the ridge structure grown before the lower blocking layer are doped to be of the first-conductivity type, the upper blocking layer and the ridge structure grown after the upper blocking layer are doped to be of the second-conductivity type, and the ridge structure in between the blocking layers is NID. Accordingly, a vertical PiN or NiP diode structure may be formed in the ridge structure.

The addition of the two charge carrier blocking layers leads to a suppression, or even a complete elimination, of non-radiative surface recombination in the ridge structure. In particular, the non-planarity of the blocking layers provides particular benefits in this respect to the ridge structure. Thus, the charge carrier density in the recombination region of the ridge structure can be increased/maximized, and a lasing ability of the electro-optical device can be improved/optimized. In particular, a threshold current density is significantly improved (i.e. lowered), i.e. by almost an order of magnitude. A quantum efficiency (QE) - which is the fraction of charge carriers that recombine radiatively in the recombination region to the total number of charge carriers injected into the electro-optical device - is improved significantly, to about 80%.

Depending on the conditions of forming the ridge structure, e.g. growth conditions, a layer/region provided on top of another layer/region may cover the side surfaces of the region/layer beneath only partly or completely. Also the thickness of the layer/region on the side surface of the region/layer beneath it can be controlled, particularly relative to the thickness of the layer/region on the top surface of the region/layer beneath it. These thicknesses may be identical or different from another. Each blocking layer may e.g. cover more or less area on the side surface of the region beneath it, depending on its growth conditions.

It is thus conceivable that the two charge carrier blocking layers touch each other in some regions of the ridge structure (for example on the side surfaces of the ridge structure). For example, by adjusting the growth conditions the amount of material grown on the side surfaces and top surfaces of the respective layer/region below can be tweaked. In an, only exemplary, extreme situation, after the lower blocking layer is deposited, the intermediate layer may be grown with conditions such that material is grown primarily on the top of the lower blocking layer. When the upper blocking layer is grown next, it may be grown on the top surface of the intermediate layer and may reach onto parts of the lower blocking layer side surfaces. In other words, the upper and lower blocking layers could potentially touch on the sides of the ridge structure.

The recombination region may be the region, in which the optical mode is concentrated, and in which the recombination of charge carriers takes place. In operation of the electro-optical device, the optical wave can (and likely will) penetrate into the top and bottom regions, respectively, but the ridge structure may be designed to maximize the overlap of the optical mode with the recombination region located in the NID region.

The Si-based support region may be a first-conductivity-type doped region, which is arranged in a top part of a Si-based substrate. The first-conductivity-type Si-based support region is in this case electrically connected to the interface between the III-V semiconductor ridge material and the Si substrate, such that a current can flow. The Si-based substrate may be a Silicon on Insulator (SOI) substrate. Notably, in this entire document, the terms "upwards", "top", "above" etc. relate to the terms "downwards", "bottom", "below" etc. according to a fabrication direction, e.g. by epitaxial growth, of the electro-optical device. That is, the "lowest" point of the ridge structure is on the support region, and the support region is "below" the ridge structure. The ridge structure extends "upwards" from the support region, and the fin structure is provide "on top" and "above" the ridge structure.

In the electro-optical device of the first aspect, and also in this entire document, the "first-conductivity-type" may be an n-type or p-type, and the "second-conductivity-type" may accordingly be a p-type or n-type. Likewise, "first-conductivity-type charge carriers" may be electrons or holes, and "second-conductivity-type charge carriers" may accordingly be holes or electrons.

In an implementation, the electro-optical device further comprises a III-V-semiconductor capping layer having a higher band-gap than the III-V semiconductor material of the ridge structure and being provided on an outer surface of the ridge structure, at least on surface regions between the lower blocking layer and the upper blocking layer. The capping layer may be NID, but may also be doped (first or second conductivity type).

The capping layer may be provided, in order to further reduce or even completely eliminate surface recombination. The capping layer may have a conduction and/or valence band offset, which is sufficiently high to prevent at least one species of electrical charge carriers (electrons and/or holes) to penetrate into this layer, and reach its surface interface with a surrounding material. The intermediate region between the two blocking layers will of course be supplied with both types of charge carriers, in order to stimulate a radiative recombination in the recombination region. While most of the charge carriers will flow to the recombination region and will recombine there, a capping layer may be particularly provided on the outer surface of the intermediate region, in case any charge carriers would otherwise recombine there.

In an implementation of the electro-optical device, the top region of the ridge structure includes an upper part forming at least one fin structure narrower than and extending upwards from a lower part of the top region.

In an implementation of the electro optical device, a width of the fin structure varies along an extension direction of the ridge structure.

By modulating the width of the fin structure, a distributed feedback (DFB) like reflector or mirror may be created. Further, a balance between diode series resistance and optical loss may be shifted. In particular, by making the fin structure wider, a wider channel for electrical current to flow into the ridge structure can be provided, but the optical mode will penetrate into the fin structure and may suffer from additional optical loss due to absorption. In advanced Laser concepts, a tuning section, a coupling section or a saturable absorber section of the device could be provided, in which the current level through the ridge structure is lower than in an amplifier section of the device. In this case, for example, the width of the fin structure may be reduced in the non-amplifying sections, in order to reduce optical loss. The penalty suffered from the increased diode series resistance will be minimal, because the current flowing through the fin structure is lower than in the amplifying section.

In an extreme case of the varying width of the fin structure, the width of the fin structure may also become zero in some locations, meaning that in some locations there is no fin structure, i.e. one or more gaps are formed between separate fin structures. Accordingly, in an implementation, the electro-optical device may comprise a plurality of the second-conductivity-type III-V-semiconductor fin structures, wherein the fin structures extend upwards from the top surface of the ridge structure, each through an associated opening in the capping layer on the top surface of the ridge structure. The fin structures may therby be arranged one after the other along the extension direction of the ridge structure.

In other words, a fin structure may be provided only in selected parts of the top surface of the ridge structure (along the extension direction of the ridge structure). For example, along the ridge structure, there may be a part, e.g. 1 µm long, with a fin structure, followed by another part, e.g. 1 µm long, without a fin structure, and so on. A pitch between the parts with and without fin structure may depend on the ridge structure design.

The fin structure is advantageously used to push the optical waveguide mode downwards, for example away from an interface with an electrode, in order to reduce the modal absorption loss, while still providing a channel to inject electrical current into the III-V ridge structure. Normally, the fin structure is arranged in the center of the top surface of the top region of the ridge structure.

In an implementation of the electro-optical device, the bottom region of the ridge structure is partly arranged in a trench formed in the support region.

In an implementation of the electro-optical device, the bottom region of the ridge structure is grown onto a V-groove formed in the support region.

According to the two implementations above, the electro-optical device can be fabricated using the ART approach. To this end, the trench formed in the support region preferably has an aspect ratio of larger than 1, more preferably larger than 1.5, most preferably larger than 3, wherein the aspect ratio is defined by its depth into the support region over its width. In this way, misfits and dislocation defects are efficiently trapped in the trench at the very bottom of the III-V semiconductor material ridge structure, such that the remaining, outgrown III-V semiconductor ridge structure is free or nearly free of defects. This leads to a better lasing ability of the device.

In an implementation of the electro-optical device, the intermediate region includes one or more quantum wells and/or quantum dots and/or quantum wires as part of the recombination region.

Although the quantum wells/wires/dots are provided for the purpose of more efficient charge carrier recombination in the recombination region, such recombination can also happen in the material surrounding these low-dimensional structures. That is, there can be parts of the ridge structure that are not the quantum wells/wires/dots etc., but can still contribute to the recombination. In particular, if the ridge structure includes a vertical PiN or NiP structure. Charge carriers can, for example, also recombine in the bulk area of the above-described intermediate region (i.e. the material surrounding the quantum wells/wires/dots). However, the carrier density in this area is usually orders of magnitude lower than the carrier density in the quantum wells/wires/dots. Moreover, the wavelength emitted due to the charge carriers recombining in that surrounding area will be significantly lower, due to the higher bandgap, than the wavelengths emitted by recombination in the narrower bandgap quantum wells/wires/dots.

In an implementation of the electro-optical device, the lower blocking layer and the upper blocking layer are each made of a III-V semiconductor material having a higher band-gap than a III-V semiconductor material forming the intermediate region.

The difference in band-gap will create a potential barrier for charge carriers to flow through. The respective doping impurities are added to the blocking layers to achieve blocking of only a single charge carrier species. A targeted conduction or valence band offset may be 100-400 meV, particularly may be 300-400 meV.

In an implementation of the electro-optical device, the intermediate region is made of GaAs, InGaAs, or InP, and the lower blocking layer and the upper blocking layer are each made of InGaP or GaAsP

These semiconductor materials are particularly suitable choices for implementing the charge carrier blocking layers. InGaP is especially suited as a hole blocking layer, but can also be used as electron blocking layer. GaAsP can likewise function as electron or hole blocking layer.

In an implementation of the electro-optical device, the lower blocking layer and the upper blocking layer are each made of GaAsP with a P-content of 30-40% and have an n-type doping level and p-type doping level, respectively, between 1E+17 cm-3 and 1E+20 cm-3.

In this implementation, for reasons of simplicity, both blocking layers are made of the same semiconductor material. The doping density can be moderate in both blocking layers.

In an implementation of the electro-optical device, the lower blocking layer or the upper blocking layer is made of InGaP with an n-type doping level between 5E+16 cm⁻³ and 5E+19 cm⁻³ or with a p-type doping level between 5E+18 cm⁻³ and 5E+20 cm⁻³.

This implementation provides either an ideal hole blocking layer (InGaP with n-type doping) or a usable electron blocking layer (InGaP with p-type doping).

In an implementation of the electro-optical device, the ridge structure comprises a narrower portion arranged on the support region and a wider portion arranged on top of the narrower portion, the narrower portion includes a lower part of the bottom region, and the wider portion includes an upper part of the bottom region, the intermediate region and at least a lower part of the top region.

The narrower portion may form a foot of the ridge structure, which is grown in the STI trench on the Si V-groove of the Si based support region, i.e. using the ART approach. The wider portion may be a body of the ridge structure that is supported on the foot. The wider structure may include a vertical PiN or NiP diode structure, where the recombination region is in the intrinsic part.

In an implementation of the electro-optical device, the ridge structure is surrounded by a dielectric.

The dielectric provides protection and stability to the ridge structure.

In an implementation, the electro-optical device further comprises: a first electrode electrically contacting the top region and configured to inject second-conductivity-type charge carriers into the ridge structure, and a second electrode electrically contacting the support region and configured to inject first-conductivity-type charge carriers into the ridge structure.

The first and second electrodes are notably also able to collect excess charge carriers (i.e. those injected charge carriers that did not recombine in the recombination region). In particular, the first electrode may collect first-conductivity-type charge carriers and the second electrode may collect second-conductivity-type charge carriers.

Preferably, the first electrode is provided on the top surface of the fin structure, because in this position it is (spatially) the furthest away from the optical mode (concentrated in the recombination region), which leads to the lowest optical loss. As mentioned above, the fin structure may be grown such that the doping density at its top is the highest, in order to ensure a particularly good electrical interface between the III-V semiconductor material of the fin structure and the electrode, e.g. realized by a contact metal.

In an implementation, the electro-optical device is a Laser, a Light Emitting Diode, or an optical amplifier.

A second aspect of the invention provides a method for fabricating a monolithic integrated electro-optical device, the method comprising: providing a first-conductivity-type Si-based support region; processing a III-V-semiconductor-material ridge structure extending from the Si-based support region by: growing a first-conductivity-type lower region onto the support region, growing a first-conductivity-type lower blocking layer for blocking second-conductivity-type charge carriers onto the top surface and parts of the side surfaces of the lower region, growing a NID intermediate region containing a recombination region onto the top and side surfaces of the lower blocking layer, growing a second-conductivity-type upper blocking layer for blocking first-conductivity-type charge carriers onto the top and side surfaces of the intermediate region, and growing a second-conductivity-type top region onto the top and side surfaces of the upper blocking layer.

The method of the second aspect achieves the same advantages as the device of the first aspect and may be extended by respective implementations as described above for the device of the first aspect.

A third aspect of the invention provides an electro-optical device that corresponds to the electro-optical device of the first aspect and its implementation forms, except that either the lower blocking layer or the upper blocking layer is omitted. That means, the ridge structure of the electro-optical device includes only one blocking layer, either the above-described lower blocking layer or the above-described upper blocking layer. The electro-optical device of the third aspect and its implementations are compatible with the implementations of the electro-optical device of the first aspect.

In an implementation of the third aspect, the electro-optical device is accordingly a monolithic integrated electro-optical device comprising: a first-conductivity-type Si-based support region; and a III-V-semiconductor-material ridge structure extending from the Si-based support region, the ridge structure including: a first-conductivity-type bottom region provided on the support region, a first-conductivity-type blocking layer provided on the top surface and parts of the side surfaces of the bottom region and configured to block second-conductivity-type charge carriers, a NID intermediate region provided on the top and side surfaces of the blocking layer and containing a recombination region, and a second-conductivity-type top region provided on the top and side surfaces of the intermediate region.

In another implementation of the third aspect, the electro-optical device is accordingly a monolithic integrated electro-optical device comprising: a first-conductivity-type Si-based support region; and a III-V-semiconductor-material ridge structure extending from the Si-based support region, the ridge structure including: a first-conductivity-type bottom region provided on the support region, a NID intermediate region provided on the top surface and parts of the side surfaces of the bottom region and containing a recombination region, a second-conductivity-type blocking layer provided on the top and side surfaces of the intermediate region and configured to block first-conductivity-type charge carriers, and a second-conductivity-type top region provided on the top and side surfaces of the blocking layer.

Either one of the blocking layers provided respectively in the ridge structure of the above implementations of the electro-optical device helps reducing surface recombination, since minority charge carriers are either prevented from reaching the upper exposed surface or from reaching the lower exposed surface (compare FIG. 7). Thus, either one of the blocking layers taken alone improves the performance of the electro-optical device, particularly as a Laser.

### BRIEF DESCRIPTION OF THE DRAWINGS

The above described aspects and implementations are explained in the following description of embodiments with respect to the enclosed drawings:
- FIG. 1: shows an electro-optical device according to an embodiment of the invention.
- FIG. 2: shows in (a) an electro-optical device according to an embodiment of the invention, and in (b) a band diagram through a cross-section of the electro-optical device showing the two charge carrier blocking layers.
- FIG. 3: shows a method according to an embodiment of the invention.
- FIG. 4: shows in (a) a threshold current for an example GaAs-on-Si ridge electro-optical device (laser) according to an embodiment of the invention with and without charge carrier blocking layers, in (b) an internal quantum efficiency with and without charge carrier blocking layers, and in (c) a surface recombination efficiency with and without charge carrier blocking layers.
- FIG. 5: shows two electro-optical devices according to embodiments of the invention.
- FIG. 6: shows an example of a III-V-on-Si ridge electro-optical device.
- FIG. 7: shows an example of a III-V-on-Si ridge electro-optical device, with indicated carrier flows and exposed III-V surfaces.

### DETAILED DESCRIPTION OF EMBODIMENTS OF THE INVENTION

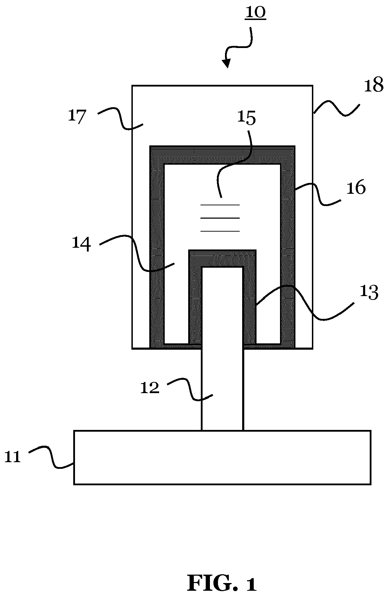

FIG. 1 shows a monolithic integrated electro-optical device 10 according to an embodiment of the invention, in particular a cross-section of the electro-optical device 10. The device 10 is particularly a III-V-on-Si ridge electro optical device. The electro-optical device 10 of FIG. 1 may in particular be a Laser, a LED, or an optical amplifier. The electro-optical device 10 may be fabricated using the nanoridge ART approach.

The device 10 particularly comprises a first-conductivity-type Si-based support region 11. The support region 11 may be a Si or Si-based (e.g. SiN) substrate. The support region 11 may also be a first-conductivity-type top region of an intrinsic Si or Si-based substrate, particularly of a SOI substrate.

The device 10 further comprises a III-V-semiconductor-material ridge structure 18 extending from the Si-based support region 11, wherein the ridge structure 18 contains a recombination region 15. The ridge structure 18 may be fabricated using the ART approach on the support region 11, i.e. may be grown in a high-aspect-ratio trench that is formed before in the support region 11. The ridge 12 may extend on the support region 11 along a direction, which is into the plane in the cross-section shown in FIG. 1.

In particular, the ridge structure 18 includes a plurality of different regions. Namely, the ridge structure 18 includes a first-conductivity-type bottom region 12, which is provided on the support region 11. The bottom region 12 may be grown in the high-aspect ratio trench mentioned above. The bottom region 12 be narrow compared to the maximum width of the ridge structure 18.

The ridge structure 19 further includes a first-conductivity-type lower blocking layer 13, which is provided on the top surface and on parts of the side surfaces of the bottom region 12, and is configured to block second-conductivity-type charge carriers. As can be seen in FIG. 1, the blocking layer 13 is non-planar, and may wrap partly around the bottom region 12. The lower blocking layer 13 may be made of a III-V semiconductor material having a higher band-gap than a III-V semiconductor material forming an intermediate region 14 of the ridge structure 18.

Accordingly, the ridge structure 18 further comprises the intermediate region 14, namely a NID intermediate region 14, which is provided on the top surface and on side surfaces of the lower blocking layer 13, and contains the recombination region 15. The intermediate region 14 is exemplarily shown in FIG. 1 to be provided on the entire side surface of the lower blocking layer 13.

Further, the ridge structure 18 includes a second-conductivity-type upper blocking layer 16, which is provided on the top surface and on side surfaces of the intermediate region 14, and is configured to block first-conductivity-type charge carriers. The blocking layer 16 may be provided on the complete outer surface of the intermediate region 14, e.g. also on an exposed bottom surface as exemplarily shown in FIG. 1. Alternatively, a capping layer maybe provided on such an exposed bottom surface, as explained below in more detail. As can be seen in FIG. 1, the blocking layer 16 is non-planar, and may at wrap around the intermediate region. The upper blocking layer 16 may be made of a III-V semiconductor material having a higher band-gap than a III-V semiconductor material forming the intermediate region 14 of the ridge structure 18.

The ridge structure 18 comprises additionally a second-conductivity-type top region 17, which is provided on the top surface and on side surfaces of the upper blocking layer 16. The top region 17 is exemplarily shown in FIG. 1 to be on the entire side surface of the upper blocking layer 16.

In the electro-optical device 10 shown in FIG. 1, the first-conductivity-type may be n-type and the second-conductivity-type p-type. First-conductivity-type charge carriers are thus electrons, and second-conductivity-type charge carriers are holed. However, these polarities could also be exchanged.

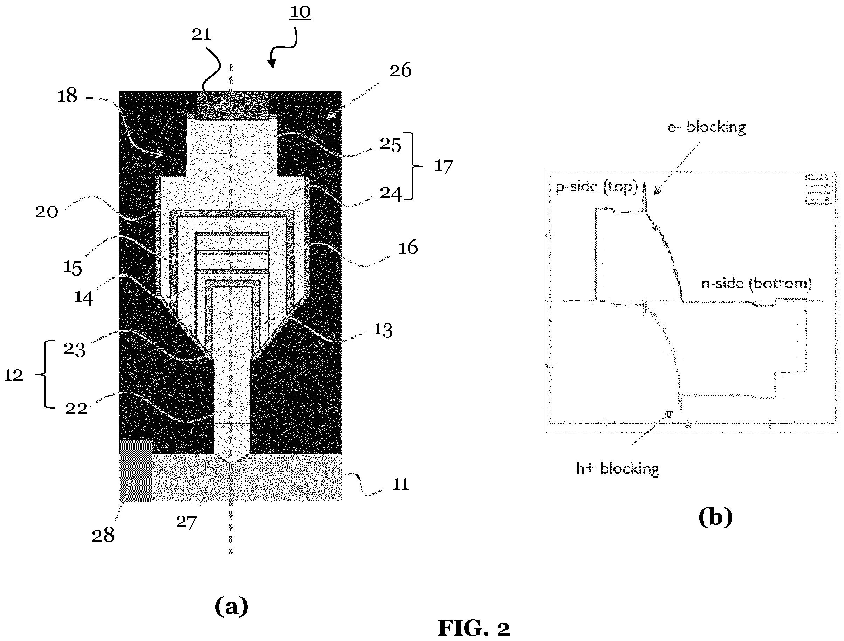

FIG. 2 shows in (a) an electro-optical device 10 according to an embodiment of the invention, in particular a cross-section of the electro-optical device 10, which builds on the device 10 shown in FIG. 1. Further, FIG. 2 shows in (b) an exemplary band diagram through a cross-section of the electro-optical device 10 shown in (a), wherein the cross-section is indicated in (a) by the dotted line. FIG. 2 (b) exemplarily assumes that the first-conductivity-type is n-type, and the second-conductivity-type is p-type. Same elements in FIG. 1 and FIG. 2 share the same reference signs and function likewise. Accordingly, also the device 10 shown in FIG. 2 (a) includes the Si-based support region 11, the III-V semiconductor material ridge structure 18, the III-V semiconductor capping layer 14, and the fin structure 15.

FIG. 2 further shows that the ridge structure 18 may include a narrower portion arranged on the support region 11, e.g. in a STI trench and/or V-groove 27 formed in the support region 11, and a wider portion arranged on top of the narrower portion. That is, the wider portion is freestanding supported by the narrower portion. The ridge structure 18 in other words is a freestanding ridge structure with a narrower foot and a wider body. The narrower portion includes a lower part 22 of the bottom region 12. The wider portion includes an upper part 23 of the bottom region 22, the intermediate region 14 and at least a lower part 24 of the top region 17. In FIG. 2, the top region 17 of the ridge structure 18 includes an upper part 25, which forms at least one fin structure, i.e. is narrower than and extends upwards from the lower part 24 of the top region 17. The fin structure may be obtained by etching the top region of the ridge structure 18.

Along the extension direction of the ridge structure 12 (i.e. into the plane in FIG. 2), the width of the fin structure 15 (left-right extension of the fin structure 15 in FIG. 2) may vary. For instance, the fin structure 15 width may vary periodically from wider to narrower and again wider. Along the extension direction of the ridge structure 12, there may even be arranged a plurality of fin structures 15 one after the other. In particular, there may be selected parts without fin structure 15 on the top surface of the ridge structure 12, and other selected parts with fin structure 15 on the top surface of the ridge structure 12. This arrangement can also be considered as a fin structure 15 with varying width along the extension direction of the ridge structure 12, wherein the width becomes zero in selected parts.

The electro-optical device 10 shown in FIG. 2 further comprises a III-V-semiconductor capping layer 20 (e.g. a passivation layer) having a higher band-gap than the III-V semiconductor material of the ridge structure 18 and being provided on an outer surface of the ridge structure 18. In FIG. 2, the capping layer 20 is shown to encapsulate the wider portion of the ridge structure 18. However, the capping layer 20 may also surround at least partly the narrower portion of the ridge structure 18. The capping layer 20 may also be provided only on parts of the outer surface of the wider portion, e.g. on the surface area between the two blocking layers 13 and 16, if the upper blocking layer 16 does not wrap completely around the outer surface of the intermediate region 14, i.e., for instance, on the above-mentioned exposed bottom surface of the intermediate region 14.

Further, FIG. 2 shows that the ridge structure 18 and the capping layer 20 may be surrounded by a dielectric 26, e.g. an oxide like SiO₂.

Further, the electro-optical device 10 may include a first electrode 21, which is in electrical contact with the top region 17, particularly the fin structure 25. The first electrode 21 is particularly configured to inject second-conductivity-type charge carriers into the ridge structure 18, and also to collect excess first-conductivity-type charge carriers from the ridge structure 18, i.e. such first-conductivity-type charge carriers that did not recombine in the recombination region 15. The device 10 may also include a second electrode 28, which is in electrical contact with the support region 11. The second electrode 28 is configured to inject first-conductivity-type charge carriers into the ridge structure 18, and also to collect excess second-conductivity-type charge carriers from the ridge structure 18, i.e. such second-conductivity-type charge carriers that were injected by the first electrode 21 and did not recombine in the recombination region 15 with the first-conductivity-type charge carriers injected by the second electrode 28. The first and/or the second electrode may be a metal contact or plug, e.g. formed by using W, Cu or another suitable metal.

Both electro-optical devices 10 shown in FIG. 1 and FIG. 2 include the lower blocking layer 13 and the upper blocking layer 16, which are used to respectively block electrons and holes, i.e. different charge carrier types. Adding different doping types to the blocking layers 13 and 16 - i.e. making them respectively of the first-conductivity type and the second-conductivity type - makes them charge-carrier-species selective blocking layers. Doping is also added to parts of the ridge structure 18, particularly below the lower blocking layer 13 and above the upper blocking layer 16, respectively. As shown in FIG. 2 in (b), this will align the conduction/valence bands of the blocking layers 13 and 16 and the access portions of the ridge structure 18, thus allowing for efficient conduction of the majority charge carriers through the layers 13 and 16, while preventing minority charge carriers to pass. In other words, the higher band-gap of the blocking layers 13 and 16 compared to the ridge structure semiconductor material will prevent minority carriers from passing through.

The level of p- and n-doping in the two blocking layers 13 and 16 and the ridge structure 18, respectively, is dependent on the choice of the semiconductor materials used for making the blocking layers 13 and 16, and more specifically dependent on the band-offsets between the blocking layers 13 and 16 and the ridge structure 18. For example:
- InGaP lattice matched to a GaAs ridge structure material has a high valence band offset to the GaAs (∼300-400 meV), compared to a moderate conduction band offset (∼100-150 meV). Thus, InGaP is ideal as a hole blocking layer in a GaAs ridge structure, and would for this require only moderate n-doping (e.g. 1E+17 cm⁻³). InGaP can also be used as an electron blocking layer, but would require a higher p-doping density (e.g. 1E+19 cm-3) to be sufficiently effective.
- GaAsP with a 30-40% phosphorous content has a more symmetric band offset compared to GaAs (as exemplary ridge structure material), and can thus function as a both a hole and electron blocking layer 13 and/or 16 with a moderate doping density (e.g. 1E+17 cm⁻³ for n-doping or p-doping).

Notably, the semiconductor and/or doping materials used for the lower blocking layer 13 and the upper blocking layer 16, respectively, are not required to be the same.

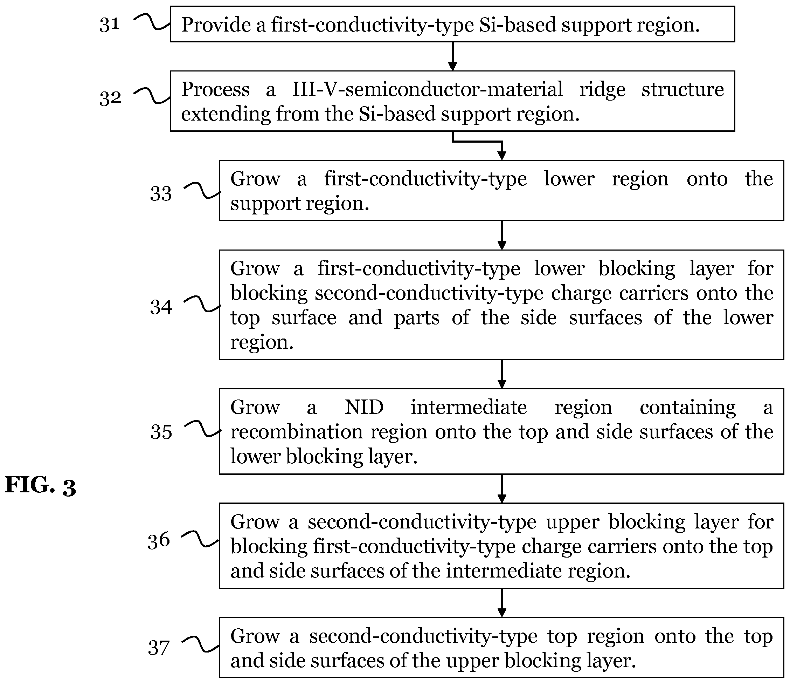

FIG. 3 shows schematically a method 30 for fabricating the device 10 according to an embodiment of the invention. The method 30 includes at least the following steps. A step 31 of providing a first-conductivity-type Si-based support region 11, and a step 32 of processing a III-V-semiconductor-material ridge structure 18 extending from the Si-based support region 11.

The step 32 may include in particular: A step 33 of growing a first-conductivity-type lower region 12 onto the support region 11; a step 34 of growing a first-conductivity-type lower blocking layer 13 for blocking second-conductivity-type charge carriers onto the top surface and onto parts of side surfaces of the lower region 12; a step 35 of growing a NID intermediate region 14 containing a recombination region 15 onto the top and side surfaces of the lower blocking layer 13; a step 36 of growing a second-conductivity-type upper blocking layer 16 for blocking first-conductivity-type charge carriers onto the top and side surfaces of the intermediate region 14; and a step 37 of growing a second-conductivity-type top region 17 onto the top and side surfaces of the upper blocking layer 16.

Notably, with the method 30, a plurality of electro-optical devices 10 may be fabricated in parallel, particularly by providing a plurality of ridge structures 18 at the same time next to another on the Si-based support region 11. For instance, the Si-based support region 11 may belong to (or be) a full wafer, particularly a 200 mm or 300 mm wafer. The wafer may finally be diced, in order to separate individual electro-optical devices 10. If the ART approach is used to produce the electro-optical devices 10, a plurality of STI trenches may be formed in the support region 11, and a ridge structure 18 may be epitaxially grown in each of the STI trenches. The method 30 is, due to its relative simplicity, able to achieve high yields of fabricating the electro-optical devices 10.

Numerical simulations show that the incorporation of the charge carrier blocking layers 13 and 16 in the electro-optical device 10, when used as a Laser, significantly improve its performance.

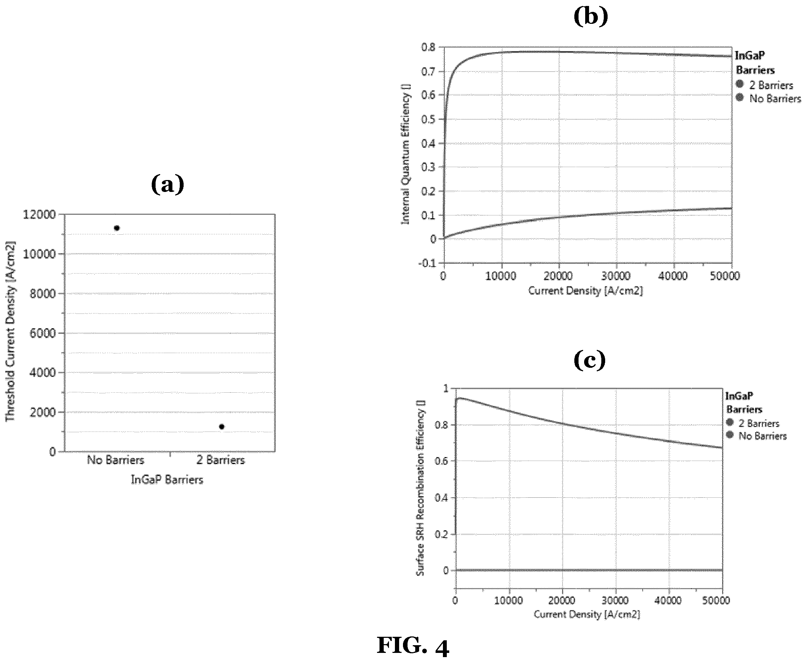

In particular, FIG. 4 shows in (a) the threshold current density for the electro-optical device 10 (2 barriers) compared with a reference device (the device shown in FIG. 6; No barriers). The compared devices particularly included a 1 mm long section of a GaAs-on-Si ridge structure with cleaved facets (Fabry-Pérot cavity). The charge carrier blocking layers 13 and 16 significantly improve the threshold current by almost an order of magnitude (i.e. from 11kA/cm² to ∼ 1kA/cm²).

FIG. 4 (b) compares the internal QE, defined as the fraction of carriers that recombine radiatively in the recombination region 15 (including QWs in this case) to the total number of carriers injected into the device. This shows that the introduction of the blocking layers 13 and 16 will improve the QE from about 6% at 10kA/cm2 (without blocking layers) to 78% at 10kA/cm² with the two blocking layers 13 and 16.

This sharp increase of the IQE can be attributed to the fact that virtually all surface recombination is eliminated due to the carrier blocking layers 13 and 16, which can be seen in FIG. 4 (c). In particular, the surface recombination efficiency drops to zero with two charge carrier blocking layers 13 and 16, regardless of the current density (between 0 and 50000 A/cm²).

By introducing the two blocking layers 13 and 16 the following was also considered:
- Although the addition of doping impurities to the blocking layers 13 and 16, and the access regions of the ridge structure 18, may provide a low resistance path for the majority carriers to reach the recombination region 15, small interface depletion regions may cause non-zero potential barriers that can cause a voltage drop, hence consuming electrical power. However, simulations show that the additional series resistance is negligible compared to other contributing factors such as contact resistance. In practice, this small increase in diode series resistance does not harm laser performance of the electro-optical device 10.
- Due to the additional doping impurities close to the recombination region 15, there may be an increase in optical propagation loss through the III-V ridge structure 18 due to free carrier absorption. However, by careful choice of the blocking layers 13 and 16 (see details above), the doping densities can be kept relatively low, which does not increase the optical loss to an unacceptable level.

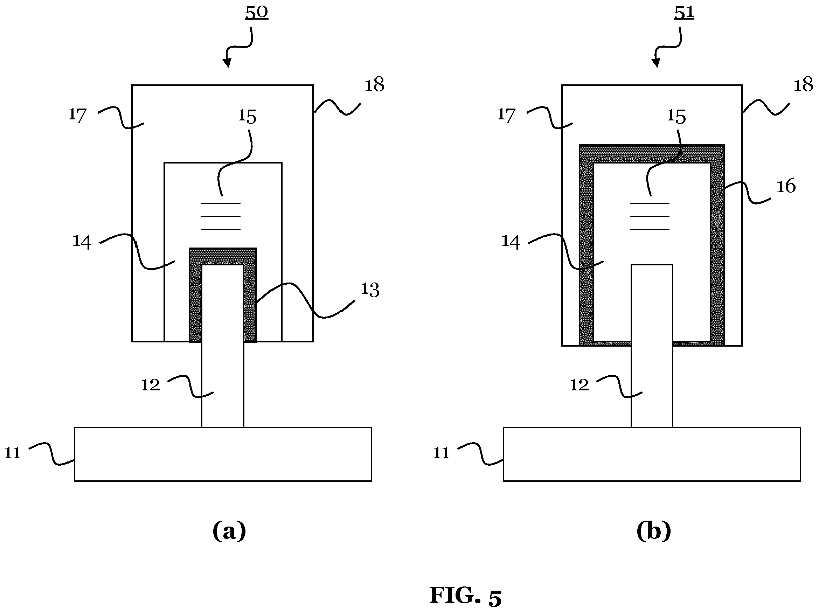

FIG. 5 shows in (a) and (b) electro-optical devices 50 and 51, respectively, according to embodiments of the invention, which build on the electro-optical device 10 shown in FIG. 1. Same elements in FIG. 1 and FIG. 5 share the same refence signs and function likewise. The devices 50 and 51 in FIG. 5 each include only one of the blocking layers 13 or 16 of the device 10 shown in FIG. 1. In particular, the device 50 shown in (a) includes only the (lower) blocking layer 13, while the device 51 in (b) includes only the (upper) blocking layer 16.

Thus, the device 50 shown in (a) is a monolithic integrated electro-optical device 50 comprising a first-conductivity-type Si-based support region 11, and a III-V-semiconductor-material ridge structure 18 extending from the Si-based support region 11. The ridge structure 18 includes a first-conductivity-type bottom region 12 provided on the support region 11, a first-conductivity-type blocking layer 13 provided on the top surface and parts of the side surfaces of the bottom region 12 and configured to block second-conductivity-type charge carriers, a NID intermediate region 14 provided on the top and side surfaces of the blocking layer 13 and containing a recombination region 15, and a second-conductivity-type top region 17 provided on the top and side surfaces of the intermediate region 14.

The device 51 shown in (b) is a monolithic integrated electro-optical device 51 comprising a first-conductivity-type Si-based support region 11, and a III-V-semiconductor-material ridge structure 18 extending from the Si-based support region 11. The ridge structure 18 includes a first-conductivity-type bottom region 12 provided on the support region 11, a NID intermediate region 14 provided on the top surface and parts of the side surfaces of the bottom region 12 and containing a recombination region 15, a second-conductivity-type blocking layer 16 provided on the top and side surfaces of the intermediate region 14 and configured to block first-conductivity-type charge carriers, and a second-conductivity-type top region 17 provided on the top and side surfaces of the blocking layer 16.

## Claims

1. Monolithic integrated electro-optical device (10), comprising:
a first-conductivity-type Si-based support region (11); and
a III-V-semiconductor-material ridge structure (18) extending from the Si-based support region (11), the ridge structure (18) including:
- a first-conductivity-type bottom region (12) provided on the support region (11),
- a first-conductivity-type lower blocking layer (13) provided on the top surface and parts of the side surfaces of the bottom region (12) and configured to block second-conductivity-type charge carriers,
- a not-intentionally-doped, NID, intermediate region (14) provided on the top and side surfaces of the lower blocking layer (13) and containing a recombination region (15),
- a second-conductivity-type upper blocking layer (16) provided on the top and side surfaces of the intermediate region (14) and configured to block first-conductivity-type charge carriers, and
- a second-conductivity-type top region (17) provided on the top and side surfaces of the upper blocking layer (16).

2. Electro-optical device (10) according to claim 1, further comprising:
a III-V-semiconductor capping layer (20) having a higher band-gap than the III-V semiconductor material of the ridge structure (18) and being provided on an outer surface of the ridge structure (18), at least on surface regions between the lower blocking layer (13) and the upper blocking layer (16).

3. Electro-optical device (10) according to claim 1 or 2, wherein:
the top region (17) of the ridge structure includes an upper part (25) forming at least one fin structure narrower than and extending upwards from a lower part (24) of the top region (17).

4. Electro-optical device (10) according to one of the claims 1 to 3, wherein:
the bottom region (12) of the ridge structure (18) is partly arranged in a trench (27) formed in the support region (11).

5. Electro-optical device (10) according to one of the claims 1 to 4, wherein:
the bottom region (12) of the ridge structure (18) is grown onto a V-groove (27) formed in the support region (11).

6. Electro-optical device (10) according to one of the claims 1 to 5, wherein:
the intermediate region (14) includes one or more quantum wells and/or quantum dots and/or quantum wires as part of the recombination region (15).

7. Electro-optical device (10) according to one of the claims 1 to 6, wherein:
the lower blocking layer (13) and the upper blocking layer (16) are each made of a III-V semiconductor material having a higher band-gap than a III-V semiconductor material forming the intermediate region (14).

8. Electro-optical device (10) according to one of the claims 1 to 7 wherein:
the intermediate region (14) is made of GaAs, InGaAs, or InP, and
the lower blocking layer (13) and the upper blocking layer (16) are each made of InGaP or GaAsP.

9. Electro-optical device (10) according to claim 8, wherein:
the lower blocking layer (13) and the upper blocking layer (16) are each made of GaAsP with a P-content of 30-40% and have an n-type doping level and p-type doping level, respectively, between 1E+17 cm⁻³ and 1E+20 cm⁻³.

10. Electro-optical device (10) according to claim 8, wherein:
the lower blocking layer (13) or the upper blocking layer (16) is made of InGaP with an n-type doping level between 5E+16 cm⁻³ and 5E+19 cm⁻³ or with a p-type doping level between 5E+18 cm⁻³ and 5E+20 cm⁻³.

11. Electro-optical device (10) according to one of the claims 1 to 10, wherein:
the ridge structure (18) comprises a narrower portion arranged on the support region (11) and a wider portion arranged on top of the narrower portion,
the narrower portion includes a lower part (22) of the bottom region (12), and
the wider portion includes an upper part (23) of the bottom region (22), the intermediate region (14) and at least a lower part (24) of the top region (17).

12. Electro-optical device (10) according to one of the claims 1 to 11, wherein:
the ridge structure (18) is surrounded by a dielectric (26).

13. Electro-optical device (10) according to one of the claims 1 to 12, further comprising:
a first electrode (21) electrically contacting the top region (17) and configured to inject second-conductivity-type charge carriers into the ridge structure (18), and
a second electrode (28) electrically contacting the support region (11) and configured to inject first-conductivity-type charge carriers into the ridge structure (18).

14. Electro-optical device (10) according to one of the claims 1 to 13, being:
a Laser, a Light Emitting Diode, or an optical amplifier.

15. Method (30) for fabricating a monolithic integrated electro-optical device (10), the method (30) comprising:
providing (31) a first-conductivity-type Si-based support region (11);
processing (32) a III-V-semiconductor-material ridge structure (18) extending from the Si-based support region (11) by:
- growing (33) a first-conductivity-type lower region (12) onto the support region (11),
- growing (34) a first-conductivity-type lower blocking layer (13) for blocking second-conductivity-type charge carriers onto the top surface and parts of the side surfaces of the lower region (12),
- growing (35) a NID intermediate region (14) containing a recombination region (15) onto the top and side surfaces of the lower blocking layer (13),
- growing (36) a second-conductivity-type upper blocking layer (16) for blocking first-conductivity-type charge carriers onto the top and side surfaces of the intermediate region (14), and
- growing (37) a second-conductivity-type top region (17) onto the top and side surfaces of the upper blocking layer (16).
